# EUROPÄISCHE PATENTSCHRIFT

(11) **EP 0 910 480 B1**
(45) Veröffentlichungstag und Bekanntmachung des Hinweises auf die Patenterteilung: **29.05.2002**
(21) Anmeldenummer: 97932737.6
(22) Anmeldetag: 03.07.1997
(51) Int. Cl.: B05C 1/08, B05C 1/16

(54) **VORRICHTUNG ZUR NASSBESCHICHTUNG INSBESONDERE VON LEITERPLATTEN MIT LACK**
DEVICE FOR WET COATING, IN PARTICULAR PRINTED CIRCUIT BOARDS WITH LACQUER
PROCEDE D'APPLICATION D'UN REVETEMENT PAR VOIE HUMIDE, NOTAMMENT DE VERNIS SUR DES CARTES DE CIRCUITS IMPRIMES

(30) Priorität: 11.07.1996 DE 29612052 U
(43) Veröffentlichungstag der Anmeldung: 28.04.1999
(73) Patentinhaber: Robert Bürkle GmbH, 72250 Freudenstadt (DE)
(72) Erfinder: MAI, Josef, D-72160 Horb (DE)
(74) Vertreter: Frank, Gerhard, Dipl.-Phys.
(86) Internationale Anmeldenummer: DE9701414
(87) Internationale Veröffentlichungsnummer: WO9802252

(56) Entgegenhaltungen:
- DE-A- 4 204 403
- DE-U- 8 503 321
- US-A- 2 102 984
- US-A- 3 568 636
- PATENT ABSTRACTS OF JAPAN vol. 6, no. 129 (P-128), 15.Juli 1982 & JP 57 053776 A (RICOH CO LTD), 30.März 1982,
- PATENT ABSTRACTS OF JAPAN vol. 007, no. 038 (P-176), 16.Februar 1983 & JP 57 191672 A (CANON KK), 25.November 1982,

## Beschreibung

### Technisches Gebiet

Die Erfindung betrifft eine Vorrichtung zur Naßbeschichtung insbesondere von Leiterplatten mit Lack, mittels mindestens einer Auftragswalze unter Aussparung mindestens eines Randbereichs der Leiterplatte, unter Verwendung einer Rakeleinrichtung.

### Stand der Technik

Eine solche Vorrichtung gemäß Oberbegriff des Anspruchs 1 ist aus dem DE-GM 85 03 321 bekannt, sie dient im wesentlichen dazu, einen lackfreien Greif-Rand bei einoder beidseitiger Beschichtung von Multilayer-Leiterplatten zu erzielen, insbesondere bei variablen Beschichtungsbreiten im Walzverfahren. Eine nähere Schilderung dieser Problematik findet sich auch in der DE-PS 44 17 518.

Bei der Rakeleinrichtung nach dem erstgenannten Gebrauchsmuster handelt es sich um zwei voneinander unabhängige Abstreifer, bei denen das Problem offen bleibt, was mit dem im Umfangsbereich der Auftragswalze abgerakelten Lack geschieht. Wird hierfür keine vernünftige Lösung angegeben, so kann diese vorbekannte Lösung zu Lackanhäufungen an unerwünschten Stellen, Verschmutzungen und Betriebsstörungen der gesamten Vorrichtung führen.

### Darstellung der Erfindung

Die wesentliche Aufgabe der Erfindung besteht also darin, solche Rakeleinrichtungen so weiterzubilden, daß sie an moderne Walzenkonzeptionen (Taktverfahren) anpaßbar sind und eine kontrollierte Verdrängung des Lackes vom Umfangsbereich der Auftragswalze gestatten.

### Bevorzugtes Ausführungsbeispiel

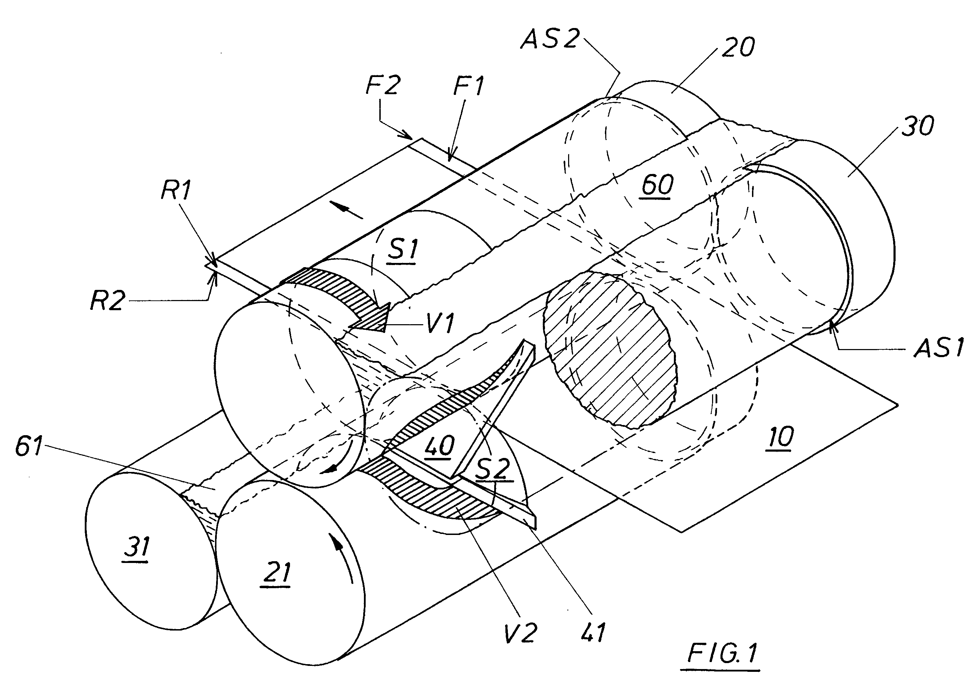

Die erfindungsgemäße Lösung ist in einer ersten Ausgestaltung anhand der perspektivischen Prinzipdarstellung der Figur 1 erkennbar:

Die zu beschichtende Multilayerplatte 10 wird wie bekannt zwischen zwei Auftragswalzen 20 und 21, die übereinander angeordnet sind und sich gegenläufig drehen, durchgeführt bzw. von diesen mitgenommen, so daß der dort haftende beispielsweise Fotoresistlack gleichmäßig vom Umfang der Auftragswalzen 20,21 auf die Multilayerplatte 10 übertragen wird. Hierbei ist es bekannt, einen ersten Rand F1/F2 der Leiterplatte 10 beschichtungsfrei dadurch zu lassen, daß an diesem Ende (in Figur 1 rechts) Auftragswalze 20 und Dosierwalze 30 so zusammenarbeiten, daß eine Beschichtung dieses Randes F1 durch die obere Auftragswalze 20 und des unteren Randes F2 durch die untere Auftragswalze 21 unterbleibt. Dies ist bei allen Leiterplattenformaten unproblematisch, da die in Figur 1 rechte Kante der Leiterplatte 10 immer entsprechend ausgerichtet werden kann.

Bei Leiterplatten wechselnder Breite nimmt jedoch der obere Rand R1 bzw. der untere Rand R2 auf der gegenüberliegenden Längsseite der Leiterplatte 10 eine wechselnde Relativposition bezüglich des Umfangs der Auftragswalzen 20,21 ein, so daß es hier erforderlich ist, einen Umfangsbereich S1,S2 auf den Auftragswalzen 20,21 vom aufgetragenen Lack zu befreien, dessen Axialposition auf den Auftragswalzen 20,21 variabel einstellbar ist.

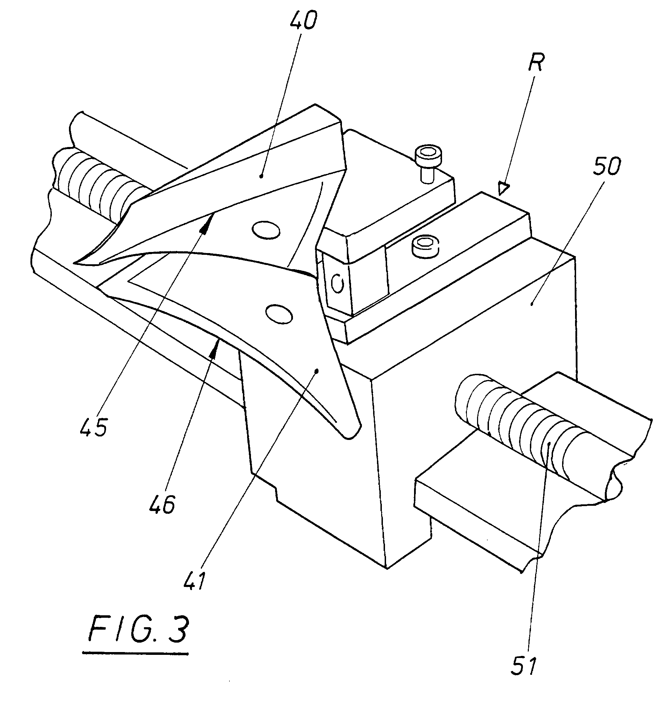

In Figur 1 ist lediglich die Rakeleinrichtung 40 dem Prinzip nach dargestellt, es handelt sich hierbei um zwei keilartig zueinander gestellte Abstreifer mit bogenförmiger Abstreifkante 45,46 (Figur 3), die miteinander einen Winkel im Bereich von 40° bis 50° bilden. Der Radius der bogenförmigen Abstreifkante 45,46 ist dabei so bemessen, daß er bei der in Figur 1 dargestellten Relativpositionierung der Abstreifer 40,41 am Umfang der Auftragswalzen 20,21 anliegt bzw. an diesen anstellbar ist.

Zwischen der oberen Auftragswalze und der oberen Dosierwalze befindet sich ein erstes, oberes Lackreservoir 60, entsprechend zwischen der unteren Auftragswalze 21 und der unteren Dosierwalze 31 ein zweites, unteres Lackreservoir 61. Die Dosierwalzen 30 und 31 sind so relativ gegenüber den Auftragswalzen 20,21 einstellbar, daß ein variabler Walzenspalt gebildet wird, über den die Dicke des Lackauftrages auf die Multilayerplatte 10 definierbar ist.

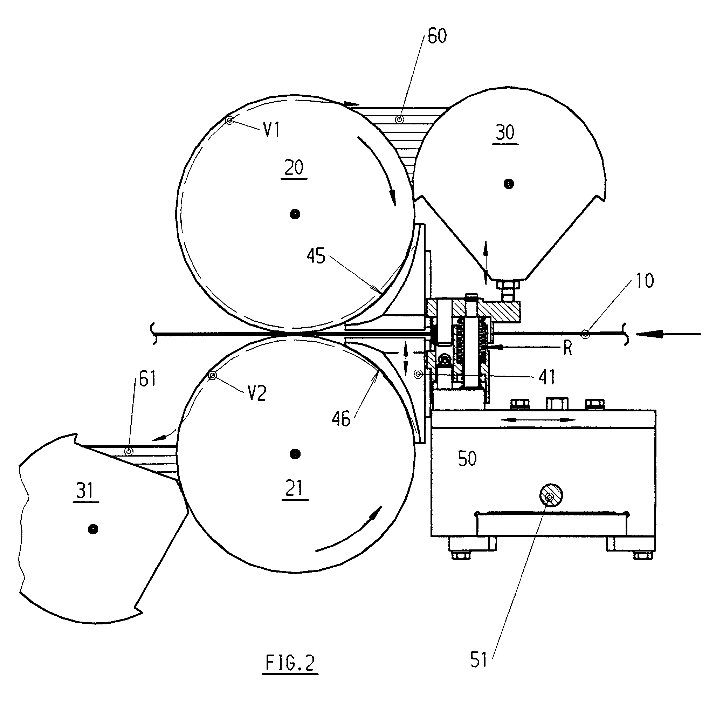

Die Relativanordnung der beiden keilförmig zueinander geneigten Abstreifer 40,41 einerseits zu den Auftragswalzen 20,21 andererseits und die Anordnung der Lackreservoire 60,61 ist nun so gewählt, daß beim Betrieb der Einrichtung, d.h. bei Drehung der Auftragswalzen 20,21 in Pfeilrichtung der bereits vom Lackreservoir aufgetragene Lack in einem Umfangsbereich S1 auf der oberen Auftragswalze 20 bzw. S2 auf der unteren Auftragswalze 21 seitlich weggeschoben wird, was durch die nicht schraffierten Umfangsflächen der Auftragswalzen 20,21 in Figur 1 zum Ausdruck gebracht werden soll. Durch diese seitliche Verdrängung des Lackes ergibt sich ein Lackstrom V1 bzw. V2, der durch die Pfeile in Figur 1 und Figur 2 dargestellt ist. Hierbei ist von wesentlicher Bedeutung, daß dieser aus den lackfrei zu stellenden Umfangsbereichen S1,S2 stammende überschüssige Lack unmittelbar über die äußeren Randbereiche der zugehörigen Auftragswalze wieder einem der beiden Lackreservoire 60,61 zugeführt wird.

Durch Verschiebung der Rakeleinrichtung, bestehend aus den Abstreifern 40 und 41 in Richtung der Längsachsen der Walzen, läßt sich die Relativlage des abgerakelten Umfangsbereichs S1,S2 auf einfache Weise so definieren, daß der gewünschte lackfreie obere Rand R1 bzw. unterer Rand R2 auf der Multilayerplatte 10 entsteht.

Die in Figur 1 zum besseren Verständnis nur schematisch dargestellten Abstreifer 40,41 sind in ihrer konstruktiven Ausgestaltung als Teil der Rakeleinrichtung R in den Figuren 2 und 3 näher dargestellt.

Beide Abstreifer 40 und 41 sitzen auf einem gemeinsamen Führungsblock 50, der mittels eines Spindeltriebs 51 verschiebbar ist, hierdurch wird die oben erwähnte axiale Verstellung und damit Definition des abgerakelten Umfangsbereichs S1,S2 auf den Auftragswalzen bewirkt. Die Rakelaufhängung ist dabei federnd ausgebildet, so daß auch bei einer in der Höhe taktender Auftragswalze die Abstreifer 40,41 immer angestellt bleiben, um bei jeder Innenlage sofort bei Anfang der Multilayerplatte 10 einen lackfreien Rand zu erzielen. Zum Reinigen sind die Abstreifer 40,41 schnell wechselbar, ebenfalls dann, wenn beim Nachschliff der Auftragswalzen in Anpassung an den kleiner gewordenen Walzendurchmesser entsprechend angepaßte Abstreifer eingesetzt werden müssen.

Die Abstreifer werden auf dem Führungsblock 50 werkseitig zentriert und justiert. Der obere Abstreifer 40 wird durch die obere Dosierwalze 30 beim Takten nach unten gedrückt und erzeugt somit den erforderlichen Anpreßdruck auf die untere Auftragswalze 21. Um diese Anpreßkräfte nicht auf den Spindeltrieb 51 zu übertragen, ist, wie oben schon erwähnt, der obere Abstreifer 40 federnd auf dem Führungsblock 50 gelagert.

Über Schrauben läßt sich eine Feinjustierung der Abstreifer erreichen.

Bei der Schnittdarstellung der Figur 2 sind die feststehenden Dosierwalzen 30,31 mit einem anderen Querschnitt versehen, der zwei Vorteile mit sich bringt:

Erstens entsteht eine Tropfkante, damit beim Reinigen kein Reinigungsmittel am Dosierwalzenmantel herunterlaufen kann und zu Verschmutzungen führt, außerdem wird bei der Positionierung der unteren Dosierwalze 31 eine Vergrößerung des unteren Lackreservoirs 61 erzielt, was im Dauerbetrieb vorteilhaft ist.

## Patentansprüche

1. Vorrichtung zur Naßbeschichtung insbesondere von Leiterplatten mit Lack mittels mindestens einer Auftragswalze unter Aussparung mindestens eines Randbereichs der Leiterplatte, unter Verwendung einer die Auftragswalze (20,21) über einen Teil ihres Umfangs beaufschlagende, in Achsrichtung verstellbare Rakeleinrichtung (R) zwischen Lackreservoir (60,61) und Leiterplatte (10) zum Abtrag des aufgetragenen Lacks in einem in der Breite variablen Umfangsbereich (S1,S2) der Auftragswalze (20,21),
**dadurch gekennzeichnet, daß** die Rakeleinrichtung (R) aus mindestens einem Abstreifer (40,41) mit einer bogenförmigen Abstreifkante (45,46) besteht, von der der vom lackfrei zu stellenden Umfangsbereich (S1,S2) abgenommene, überschüssige Lack unmittelbar über die äußeren Randbereiche der zugehörigen Auftragswalze (20,21) wieder einem der zwischen Auftragswalze (20,21) und Dosierwalze (30,31) gebildeten Lackreservoire (60,61) zugeführt wird.

2. Vorrichtung nach Anspruch 1, **dadurch gekennzeichnet, daß** bei der beidseitigen Naßbeschichtung die Rakeleinrichtung (R) aus zwei im wesentlichen zur Leiterplattenebene symmetrisch gehaltenen, keilartig einander zugeordneten Abstreifern (40,41) gebildet ist, die jeweils an einer oberen und einer unteren Auftragswalze (20,21) angreifen.

3. Vorrichtung nach Anspruch 2, **dadurch gekennzeichnet, daß** die Abstreifer (40,41) an einem gemeinsamen Führungsblock (50) befestigt sind, der an einem parallel zur Ebene der Leiterplatte (10) angeordneten Spindeltrieb (51) zur Einstellung des abzurakelnden Randbereichs (S1,S2) horizontal verschiebbar gehalten ist.

4. Vorrichtung nach Anspruch 1, **dadurch gekennzeichnet, daß** die Rakeleinrichtung (R) in Richtung der Längsachse der Auftragswalze (20,21) verschiebbar ist.

5. Vorrichtung nach Anspruch 1,3 und 4, **dadurch gekennzeichnet, daß** die Rakeleinrichtung (R) so positioniert an die Auftragswalzen (20,21) anstellbar ist, daß der abgerakelte Umfangsbereich (S1,S2) der Auftragswalzen (20,21) zu einem lackfreien Randbereich (R1,R2) der beschichteten Leiterplatte (10) in der gewünschten Breite führt.

6. Vorrichtung nach Anspruch 1, **dadurch gekennzeichnet, daß** die Auftragswalzen (20,21) vertikal übereinander angeordnet sind und die zugehörigen feststehenden Dosierwalzen (30,31) seitlich zur Bildung des oberen und unteren Lackreservoirs (60,61).

7. Vorrichtung nach Anspruch 1, **dadurch gekennzeichnet, daß** der Querschnitt der Dosierwalzen (30,31) eine Einschnürung aufweist, durch die eine Tropfkante gebildet wird.

8. Vorrichtung nach Anspruch 3, **dadurch gekennzeichnet, daß** die Abstreifer (40,41) am Führungsblock (50) federnd gehalten sind.

9. Vorrichtung nach Anspruch 1, **dadurch gekennzeichnet, daß** zur Erzeugung eines feststehenden, beschichtungsfreien Randes (F1,F2) auf der Multilayerplatte (10) Auftragswalze (20,21) und zugeordnete Dosierwalze (30,31) jeweils einen ineinandergreifenden Absatz (AS1,AS2) aufweisen.

## Claims

1. Apparatus for wet-coating, more especially, printed circuit boards with lacquer by means of an applicator roller so as to spare at least one edge region of the printed circuit board, using a doctor arrangement (R), which acts upon the applicator roller (20,21) over a portion of its circumference and is adjustable in the axial direction, between lacquer reservoir (60,61) and printed circuit board (10) for the removal of the applied lacquer in a circumferential region (S1,S2), of variable width, of the applicator roller (20,21), **characterised in that** the doctor arrangement (R) comprises at least one wiper (40,41) with an arcuate wiping edge (45,46), from which the excess lacquer, removed from the circumferential region (S1,S2) which is to be lacquer-free, is returned directly to one of the lacquer reservoirs (60,61), formed between applicator roller (20,21) and metering roller (30,31), via the external edge regions of the associated applicator roller (20,21).

2. Apparatus according to claim 1, **characterised in that**, to achieve the wet-coating on both sides, the doctor arrangement (R) is formed from two wipers (40,41), which are kept substantially symmetrical relative to the plane of the printed circuit board and are associated with each other in a wedge-like manner, said wipers each co-operating with an upper and lower applicator roller (20,21) respectively.

3. Apparatus according to claim 2, **characterised in that** the wipers (40,41) are mounted on a common guide block (50), which is kept horizontally displaceable on a spindle drive (51), disposed parallel to the plane of the printed circuit board (10), to set the edge region (S1,S2) to be wiped.

4. Apparatus according to claim 1, **characterised in that** the doctor arrangement (R) is displaceable in the direction towards the longitudinal axis of the applicator roller (20,21).

5. Apparatus according to claims 1, 3 and 4, **characterised in that**, when positioned on the applicator rollers (20,21), the doctor arrangement (R) is so adjustable that the wiped circumferential region (S1,S2) of the applicator rollers (20,21) leads to a lacquer-free edge region (R1,R2) of the coated printed circuit board (10) of desired width.

6. Apparatus according to claim 1, **characterised in that** the applicator rollers (20,21) are disposed vertically one above the other, and the associated stationary metering rollers (30,31) are disposed laterally to form the upper and lower lacquer reservoirs (60,61).

7. Apparatus according to claim 1, **characterised in that** the cross-section of the metering rollers (30,31) has a constriction, by means of which a drip edge is formed.

8. Apparatus according to claim 3, **characterised in that** the wipers (40,41) are resiliently retained on the guide block (50).

9. Apparatus according to claim 1, **characterised in that**, to produce a fixed, coating-free edge (F1,F2) on the multilayer board (10), applicator roller (20,21) and associated metering roller (30,31) each have a shoulder portion (AS1,AS2), which shoulder portions engage in each other.

## Revendications

1. Dispositif pour l'application d'un revêtement par voie humide, en particulier d'un vernis sur des cartes de circuits imprimés, au moyen d'au moins un rouleau d'application en réservant au moins une zone de bordure de la carte imprimée, en utilisant un dispositif de raclage (R) entre le réservoir de vernis (60, 61) et la carte imprimée (10) pour l'enlèvement du vernis appliqué dans une zone périphérique (S1, S2), variable en largeur, du rouleau d'application (20, 21), ce dispositif de raclage sollicitant le rouleau d'application (20, 21) sur une partie de son pourtour et étant déplaçable dans le sens axial, **caractérisé en ce que** le dispositif de raclage (R) se compose d'au moins un racloir (40, 41) avec une arête de raclage (45, 46) en forme d'arc, par lequel le vernis excédentaire, retiré de la zone périphérique (S1, S2) à débarrasser du vernis, est directement renvoyé par l'intermédiaire des zones de bordure externes du rouleau d'application correspondant (20, 21) à un réservoir de vernis (60, 61), formé entre le rouleau d'application (20, 21) et le rouleau de dosage (30, 31).

2. Dispositif suivant la revendication 1, **caractérisé en ce que**, dans l'application bilatérale du revêtement par voie humide, le dispositif de raclage (R) est formé de deux racloirs (40, 41) mutuellement associés en forme de coin, maintenus essentiellement de façon symétrique par rapport au plan de la carte imprimée, et qui attaquent respectivement un rouleau supérieur et un rouleau inférieur d'application (20, 21).

3. Dispositif suivant la revendication 2, **caractérisé en ce que** les racloirs (40, 41) sont fixés sur un coulisseau (50) commun; qui est maintenu avec une possibilité de déplacement dans le sens horizontal sur un dispositif d'entraînement à broche (51), disposé parallèlement au plan de la carte imprimée (10), pour le réglage de la zone de bordure (S1, S2) à racler.

4. Dispositif suivant la revendication 1, **caractérisé en ce que** le dispositif de raclage (R) peut se déplacer en direction de l'axe longitudinal du rouleau d'application (20, 21).

5. Dispositif suivant l'une des revendications 1, 3 et 4, **caractérisé en ce que** le dispositif de raclage (R) est réglable avec un positionnement tel sur les rouleaux d'application (20, 21) que la zone périphérique (S1, S2) raclée des rouleaux d'application (20, 21) provoque une zone de bordure (R1, R2) sans vernis, de la largeur souhaitée, de la carte imprimée (10) revêtue.

6. Dispositif suivant la revendication 1, **caractérisé en ce que** les rouleaux d'application (20, 21) sont superposés dans le sens vertical, et les rouleaux de dosage (30, 31) stationnaires correspondants sont disposés latéralement pour la formation du réservoir de vernis supérieur et inférieur (60, 61).

7. Dispositif suivant la revendication 1, **caractérisé en ce que** la section transversale des rouleaux de dosage (30, 31) présente un rétrécissement, par lequel est formée une arête d'égouttage.

8. Dispositif suivant la revendication 3, **caractérisé en ce que** les racloirs (40, 41) ont un maintien élastique sur le coulisseau (50).

9. Dispositif suivant la revendication 1, **caractérisé en ce que**, pour produire un bord (F1, F2) fixe, sans revêtement, sur le circuit imprimé multicouche (10), le rouleau d'application (20, 21) et le rouleau de dosage associé (30, 31) présentent chacun un épaulement (AS1, AS2) en prise mutuelle.
